# EUROPEAN PATENT SPECIFICATION

(11) **EP 1 111 489 B1**
(45) Date of publication and mention of the grant of the patent: **22.10.2003**
(21) Application number: 00123536.5
(22) Date of filing: 27.10.2000
(51) Int. Cl.: G05D 3/12, H02N 1/00, G01B 11/02, H02P 7/63

(54) **Two-dimensional positioning apparatus and method for measuring laser light from the apparatus**
Zwei-dimensionale Positionierungseinrichtung und Verfahren zur Messung von Laserlicht der Einrichtung
Méthode et appareil de positionnement bi-dimensionel et méthode pour mesurer une lumière laser de l'appareil

(30) Priority: 29.10.1999 JP 30879799; 22.11.1999 JP 33148099; 25.11.1999 JP 33465399; 29.11.1999 JP 33838399
(43) Date of publication of application: 27.06.2001
(73) Proprietor: Yokogawa Electric Corporation, Tokyo 180-8750 (JP)
(72) Inventor: Ono, Yutaka, c/o Yokogawa Electric Corp., Musashino-shi, Tokyo 180-8750 (JP); Hashida, Shigeru, c/o Yokogawa Electric Corp., Musashino-shi, Tokyo 180-8750 (JP); Koizumi, Yutaka, c/o Yokogawa Electric Corp., Musashino-shi, Tokyo 180-8750 (JP); Kaiho, Fumio, c/o Yokogawa Electric Corp., Musashino-shi, Tokyo 180-8750 (JP); Kosugi, Yasuhito, c/o Yokogawa Electric Corp., Musashino-shi, Tokyo 180-8750 (JP); Jimbo, Ryuichi, c/o Yokogawa Electric Corp., Musashino-shi, Tokyo 180-8750 (JP); Kimura, Atsufumi, c/o Yokogawa Electric Corp., Musashino-shi, Tokyo 180-8750 (JP)
(74) Representative: Henkel, Feiler, Hänzel

(56) References cited:
- EP-A- 0 533 403
- EP-A- 0 637 870
- EP-A- 0 911 952
- WO-A-99/42785
- US-A- 4 657 392
- US-A- 4 719 400
- US-A- 5 450 195
- US-A- 5 585 683

## Description

### BACKGROUND OF THE INVENTION

### 1. Field of the Invention

The present invention is applicable to probers, handlers, steppers and other equipment and relates to two-dimensional positioning apparatus for positioning objects in a two-dimensional direction.

### 2. Description of the Prior Art

As two-dimensional positioning apparatus, there has been an apparatus described in the specification of the unexamined patent application publication 2000-65970 also filed by the applicant of the present invention. FIG. 1 is a schematic view of the above-mentioned apparatus.

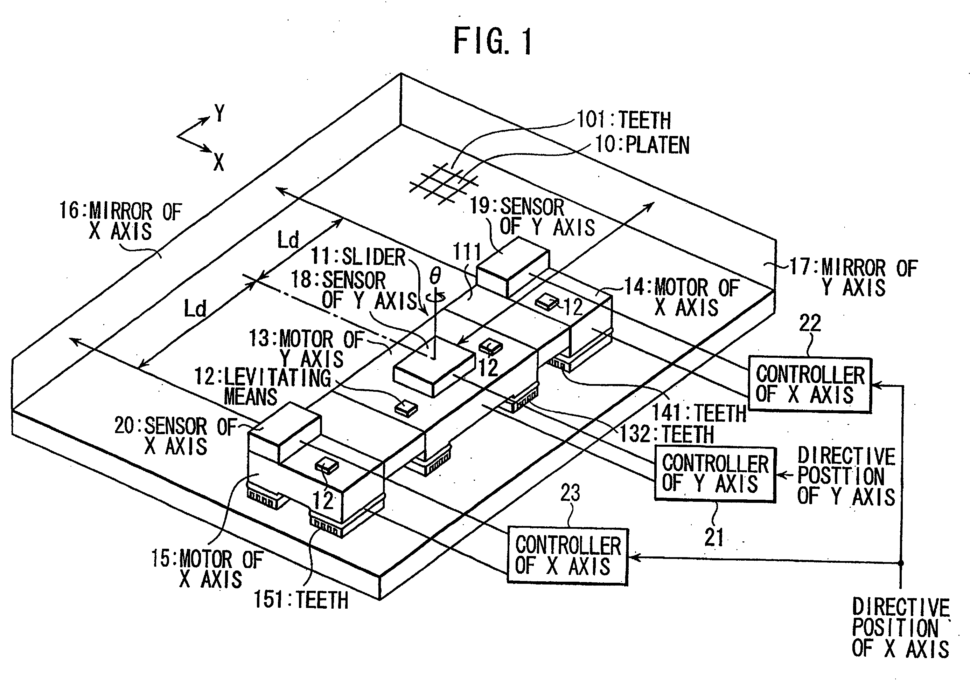

In FIG. 1, a platen 10, which is made of a magnetic material, is provided with teeth formed at fixed spacings in the X-axis and Y-axis directions. The figure shows only part of the teeth, however, for simplification.

An object being positioned is placed on a slider 11.

Levitating means 12 causes the slider 11 to levitate above the platen 10. Nozzles are formed on the surface of the slider 11 facing the platen 10. Jets of compressed air are sent out through the nozzles by the levitating means 12 to produce levitational force.

A Y-axis motor 13 is mounted on the slider 11 and teeth 132 are formed on the Y-axis motor 13 at fixed spacings in the Y-axis direction. The Y-axis motor 13 produces magnetic 'attractive force between the teeth 132 and the teeth 101 of the platen 10 to cause the slider 11 to move in the Y-axis direction.

X-axis motors 14 and 15 are mounted on the slider 11 to be symmetrically opposite with each other in relation to the center point of the slider 11. Teeth 141 and 151 are formed on the X-axis motors 14 and 15 at fixed spacings in the X-axis direction. The X-axis motors 14 and 15 produce magnetic attractive force between the teeth 141 and 101 and between the teeth 151 and 101, to cause the slider 11 to move in the X-axis direction.

Connecting members 111 and 112 connect the Y-axis motor 13 with both the X-axis motors 14 and 15.

An X-axis mirror 16 is attached to one side of the platen 10, and a mirror surface is formed in the Y-axis direction. A Y-axis mirror 17 is attached to another side adjacent to the above-mentioned side of the platen 10, and a mirror surface is formed in the X-axis direction.

A Y-axis position sensor 18, which is mounted on the Y-axis motor 13, is a laser interferometer that emits light beams to the Y-axis mirror 17, receives catoptric light beams from the Y-axis mirror 17, and detects the Y-axis position of the slider 11 by means of optical interference.

X-axis position sensors 19 and 20, which are mounted on the X-axis motors 14 and 15, respectively, are laser interferometers that emit light beams to the X-axis mirror 16, receive catoptric light beams from the X-axis mirror 16, and detect the X-axis position of the slider 11 by means of optical interference.

A Y-axis controller 21 feedback-controls the position of the slider 11 according to the deviation of a Y-axis directive position from a position detected by the Y-axis position sensor 18.

X-axis controllers 22 and 23 feedback-control the position of the slider 11 according to the deviations of X-axis directive positions from positions detected by the X-axis position sensors 19 and 20.

A rotational error may occur around an axis perpendicular to the X and Y axes of the slider 11. This phenomenon is referred to as yawing and the angle of the rotational error (i.e., yaw angle) is assumed to be θ.

In the prior art apparatus of FIG. 1, the X-axis and θ-axis positions are controlled by giving the same position command to the X-axis controllers 22 and 23. The state in which any yawing in the slider 11 has been eliminated is defined as θ = 0.

For light beams emitted by the Y-axis position sensor 18 and X-axis position sensors 19 and 20 toward mirrors to be able to correctly return to their respective sensors, the yaw angle must be maintained at nearly zero, i.e., θ ≈ 0. If θ deflects largely, the light beams emitted by the Y-axis position sensor 18 and X-axis position sensors 19 and 20 will fail to return to the sensors. Consequently, the position of the slider 11 becomes unknown, and therefore the position and speed of the slider 11 cannot be feedback-controlled. Since position sensors in the prior art apparatus of FIG. 1 are optical sensors using laser interferometers, even a small rotational error of the slider 11 can result in uncontrollability.

In the prior art apparatus of FIG. 1, it has been difficult to bring θ close to 0 for the following reasons.

Reason 1: It is not possible to separately set the control characteristics of the θ-axis and X-axis directions.

To be able to perform control so as to satisfy θ ≈ 0, the servomechanical rigidity of θ may be increased. In the case of the prior art apparatus of FIG. 1, however, the servomechanical rigidity in the θ-axis direction is uniquely fixed when the control methods and bandwidths of the X-axis controllers 22 and 23 are fixed.

Reason 2: Control in the θ-axis direction becomes infeasible when acceleration in the X-axis direction is at its maximum.

The output torque T of the slider 11 in FIG. 1 is represented by the following equation:$\text{T = Fx2·Lx2 - Fx1·Lx1}$ where
Fx1 is the propulsion of the X-axis motor 14;
Fx2 is the propulsion of the X-axis motor 15;
Lx1 is a Y-axis distance from the center of gravity of the slider 11 to the center point of the X-axis motor 14; and
Lx2 is a Y-axis distance from the center point of the X-axis motor 15 to the center of gravity of the slider 11.

If the load on the slider 11 is large and the value of an acceleration/deceleration command for the X-axis direction is also large, the propulsion Fx1 and Fx2 of the X-axis motors 14 and 15 can be at their maximum. Assuming the maximum values of Fx1 and Fx2 to be Fx1max and Fx2max, then the output torque T of the slider 11 is$\text{T = Fx2max·Lx2 - Fx1max·Lx1}$

If Fx1max·Lx1 ≠ Fx2max·Lx2 holds true for reasons of manufacturing variations, then θ will increase. Even when Fx1max·Lx1 = Fx2max·Lx2 is true, θ will also increase and servo control becomes infeasible if a disturbing torque Td is applied.

As discussed above, in the prior art apparatus of FIG. 1, propulsion is consumed only for control in the X-axis direction, and no regard is paid to consuming propulsion for control in the θ-axis direction. This approach has often resulted in the problem that the maximum propulsion of the two X-axis motors becomes unbalanced, or θ increases when, for example, a disturbing torque interferes and therefore servo control becomes infeasible.

EP-A 0 911 952 discloses a two dimensional positioning apparatus comprising a platen and a slider. The slider being suspended above the platen by means of springs. The apparatus further comprises means for moving the slider in x and y direction.

US-A 5 585 683 discloses a further two dimensional positioning apparatus comprising means for rotating a slider suspended above a platen. The apparatus includes an electrostatic motor, such that the moving element is placed on the stationary member.

### SUMMARY OF THE INVENTION

The present invention has been made to solve the above-mentioned problem. Hence it is a general object of the invention to provide a two-dimensional positioning apparatus that can prevent position control from becoming infeasible due to a rotational error in a slider, by performing control separately in the X-axis and θ-axis directions.

The above object is achieved by a two dimensional positioning apparatus according to claim 1. The dependent claims are related to further advantageous aspects of the invention.

### BRIEF DESCRIPTION OF THE DRAWINGS

FIG. 1 is a schematic view of a prior art two-dimensional positioning apparatus.
FIG. 2 is a schematic diagram showing one embodiment of the present invention.
FIG. 3 is a simplified view of the diagram of the control system shown in FIG. 2.
FIG. 4 is a schematic view showing an arrangement example of motor cores present in X-axis and Y-axis motors.
FIG. 5 is a schematic view showing a configuration example of the motor cores present in the X-axis and Y-axis motors.
FIG. 6 is a schematic view showing a configuration example of sensors used in the apparatus of FIG. 2.
FIG. 7 is a schematic view showing another configuration example of the sensors used in the apparatus of FIG. 2.
FIG. 8 is a schematic view showing yet another configuration example of the sensors used in the apparatus of FIG. 2.
FIG. 9 is a schematic view showing a pattern of interference fringes.
FIG. 10 is a schematic diagram showing a configuration example of a motor drive circuit used in the apparatus of FIG. 2.
FIG. 11 is a schematic diagram showing another configuration example of the motor drive circuit used in the apparatus of FIG. 2.
FIG. 12 is a timing chart showing the relationship among signals in the circuit diagram of FIG. 11.
FIG. 13 is a schematic view showing a configuration example of a two-dimensional positioning apparatus provided with means for detecting laser light wavelengths.
FIG. 14 is a schematic view showing a configuration example of an origin sensor.
FIG. 15 is a schematic view explaining the behavior of the apparatus of FIG. 13.
FIG. 16 is a schematic view also explaining the behavior of the apparatus of FIG. 13.
FIG. 17 is a graphical view also explaining the behavior of the apparatus of FIG. 13.

### DESCRIPTION OF THE PREFERRED EMBODIMENTS

Preferred embodiments of the present invention, along with component configurations thereof, will be described in detail hereinafter, with reference to the accompanying drawings.

### (1) Configuration of Servo Control System

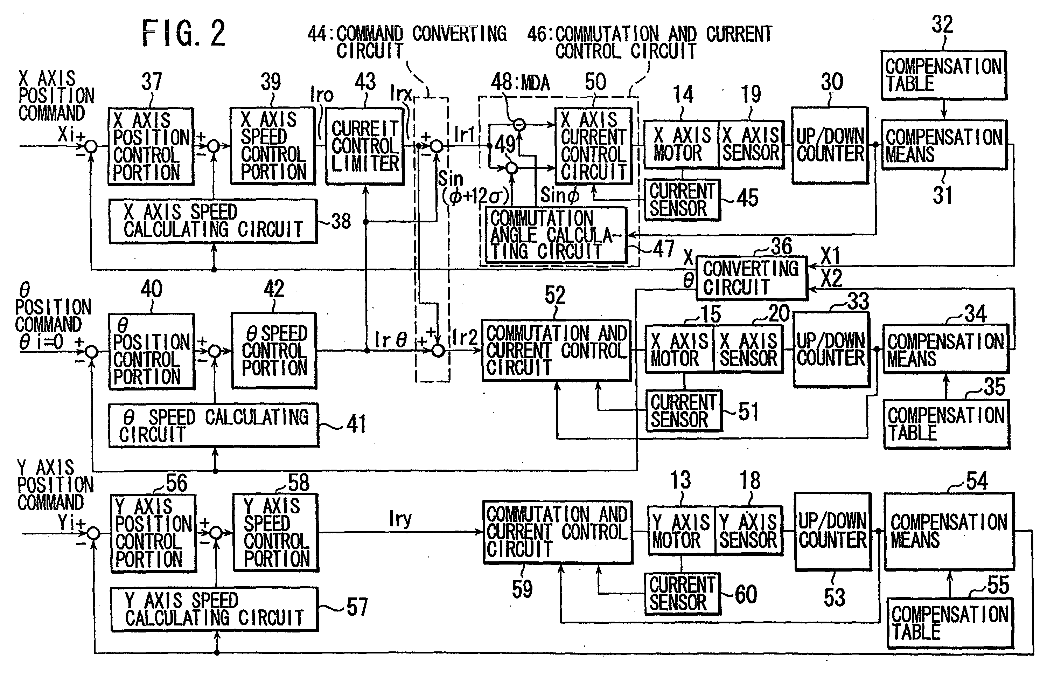

FIG. 2 is a schematic diagram showing one embodiment of the present invention. Elements that are the same as those discussed in the preceding figure are given the same references.

FIG. 2 is, more specifically, a schematic diagram showing the configuration of a servo control system. The platen, slider, levitating means, X-axis motors, Y-axis motor, X-axis position sensors, Y-axis position sensor, X-axis mirrors and Y-axis mirror in FIG. 2 are all similar to those in the prior art apparatus of FIG. 1.

In FIG. 2, the X-axis position sensor 19 identifies the direction in which the slider 11 moves, and generates count-up or count-down pulses depending on the direction identified. The number of pulses generated is relative to the amount of movement made by the slider 11. An up-down counter 30 counts up or down according to the count-up or count-down pulses generated. The count given by the up-down counter 30 represents the detected position of the slider 11. The configuration of the X-axis position sensor 19 is explained later.

Compensation means 31 contains a compensation table 32 wherein positions of the slider dependent on the curvature of mirrors are made to correspond with the amounts of correction necessary to eliminate any yawing in the slider 11. The compensation means 31 reads an amount of correction from the compensation table 32 according to a given directive position, and corrects the position detected by the up-down counter 30 using the amount of correction that the means has read. It should be noted here that data contained in the compensation table 32 are those obtained by means of calibration.

The compensation means 31 is provided in order to correct curvatures in the X-axis and Y-axis mirrors 16 and 17 of FIG. 1 due to mechanical errors. The compensation means 31 may not be necessarily provided if the curvatures in the X-axis and Y-axis mirrors 16 and 17 are not so serious as to affect position detection.

Like the X-axis position sensor 19, the X-axis position sensor 20 is also provided with an up-down counter 33, compensation means 34, and a compensation table 35.

The converting circuit 36 receives signals for detected X-axis positions X1 and X2 from the compensation means 31 and 34, and converts these signals to signals for the X-axis position x of the center point of the slider 11 and the yaw angle θ of the slider. The conversion formula is as follows:$\text{X = (X1 + X2)/2; θ = (x2 -x1)/2Ld}$ where, Ld is the distance from the center point of the slider 11 to the optical axis of the X-axis position sensor 19 or 20 (Ld is indicated in FIG. 1).

An X-axis position controller 37 outputs a control signal for feedback-controlling the X-axis position of the slider 11 according to the deviation of an X-axis position command Xi from the detected position x.

From the rate of change in the detected position x, an X-axis speed-calculating circuit 38 detects the speed at which the slider 11 moves in the X-axis direction. The X-axis speed-calculating circuit 38 is, for example, an F/V converter.

An X-axis speed controller 39 outputs a control signal for feedback-controlling the speed at which the slider 11 moves in the X-axis direction, according to the deviation of the control signal of the X-axis position controller 37 from a speed detected by the X-axis speed-calculating circuit 38. This control signal serves as a propulsion command Ir0 for moving the slider in the X-axis direction.

Similarly, the apparatus is provided with a θ-axis position controller 40, θ-axis speed-calculating circuit 41, and a θ-axis speed controller 42, in order to control the yaw angle θ. A control signal provided by the θ-axis speed controller 42 serves as a propulsion command Irθ for rotating the slider in the θ-axis direction.

A limiter 43 restricts the X-axis limits of the propulsion command Ir0 to Imax - |Irθ| (Imax is the maximum value of the propulsion command) and outputs a propulsion command Irx after restriction. This propulsion command restricts the X-axis limits of the-propulsion command Ir0 according to the magnitude of the θ-axis propulsion command Irθ.

A command converting circuit 44 converts the propulsion command Irx for the X-axis direction and propulsion command Irθ for the θ-axis direction to the propulsion commands Ir1 and Ir2 of the X-axis motors 14 and 15, according to the following formulas:$\text{Ir1 = Irx - Irθ; Ir2 = Irx + Irθ}$

The propulsion commands Ir1 and Ir2 will fall within the range from -Imax to +Imax by virtue of the limiter 43.

A current sensor 45 detects an electric current that flows through the coil of the X-axis motor 14.

A commutation and current control circuit 46 controls the commutation of the X-axis motor 14 and an electric current flowing through the coil of the X-axis motor 14.

A commutation angle calculating circuit 47 has a sine table containing counts of the up-down counter 30 and their corresponding sine values. If a count of the up-down counter 30 is given in a case when the X-axis motor 14 is of 3-phase type, the commutation angle calculating circuit 47 reads the values of sin φ and sin (φ + 120°) from the sine table. Here, φ is an angle that changes according to the count of the up-down counter 30.

Multiplying digital-to-analog converters (abbreviated as MDAs) 48 and 49 output the current commands Ir1sin φ and Ir1sin (φ + 120°), using the propulsion command Ir1 as an analog input signal and the values of sin φ and sin (φ + 120°), which were read from the sine table, as gain-setting signals. Here, the reason for the 120° phase shift in the two commands is because the X-axis motor 14 is a 3-phase motor. The phase shift will vary if the number of phases differs.

An X-axis current control circuit 50 controls an electric current flowing through the coil of the X-axis motor 14 according to deviations of the current commands Ir1sin φ and Ir1sin (φ + 120°) from currents detected by the current sensor 45.

Similarly, the X-axis motor 15 is also provided with a current sensor 51 and a commutation and current control circuit 52.

Like the X-axis and θ-axis servo control systems, the Y-axis servo control system is also provided with an up-down counter 53, compensation means 54, a compensation table 55, a Y-axis position controller 56, a Y-axis speed-calculating circuit 57, a Y-axis speed controller 58, and a commutation and current control circuit 59. In the Y-axis servo control system, control is performed without going through such a process of converting control variables as is done by the converting circuit 36.

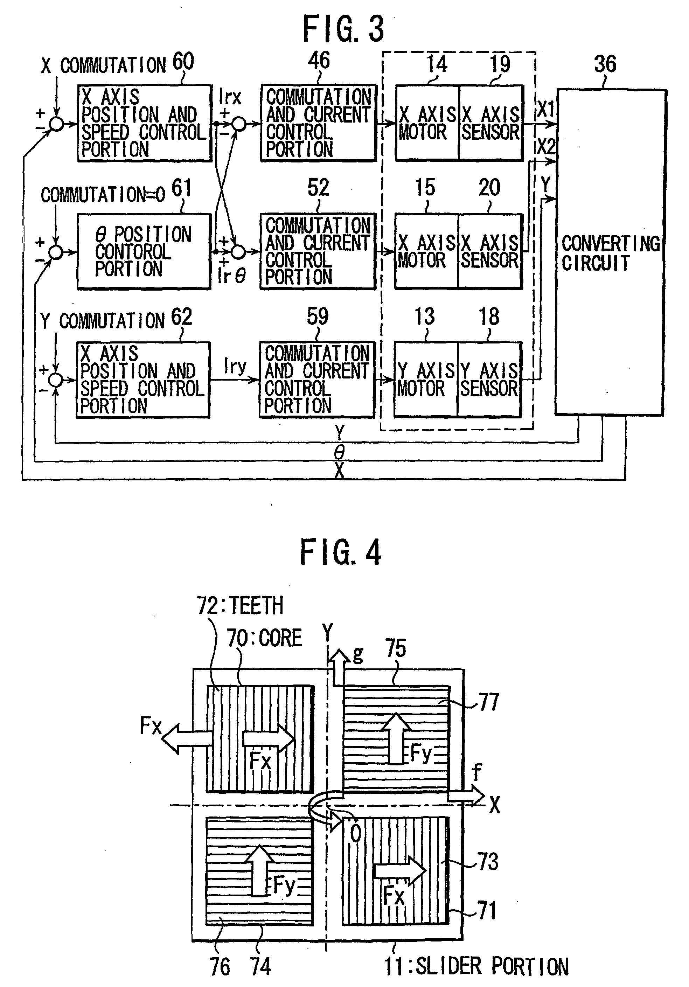

FIG. 3 is a simplified view of the diagram of the control system shown in FIG. 2.

In FIG. 3, the converting circuit 36 converts values X1, X2 and Y detected by the X-axis position sensor 19, X-axis position sensor 20 and Y-axis position sensor 18 to the X-axis position x of the slider 11's center point and the yaw angle θ and Y-axis position Y of the slider 11.

An X-axis position and speed controller 60 feedback-controls the X-axis position and speed of the slider 11 using the signal of position x as a feedback signal. The control signal of the X-axis position and speed controller 60 is output as a propulsion command Irx for the X-axis direction.

A θ-axis position and speed controller 61 feedback-controls the θ-axis position and speed of the slider 11 using the signal of the yaw angle θ as a feedback signal. The control signal of the θ-axis position and speed controller 61 is output as a propulsion command Irθ for the θ-axis direction.

At this point, the propulsion commands Irx and Irθ are converted to Irx - Irθ and Irx + Irθ, i.e., the propulsion commands of the X-axis motors 14 and 15.

Thus, control is performed separately for the X-axis and θ-axis directions.

A Y-axis position and speed controller 62 feedback-controls the Y-axis position and speed of the slider 11 using the signal of position Y as a feedback signal. The control signal of the Y-axis position and speed controller 62 is output as a propulsion command Iry for the Y-axis direction.

According to the servo control system explained above, the following advantages are offered.
[1] Signals detected by the Y-axis position sensor and two X-axis position sensors are converted to the X-axis position signal of the slider 11's center point and the signal of the slider 11's yaw angle θ. Then, according to the converted signals, feedback control is performed separately for the slider 11's movement in the X-axis and θ-axis directions. Consequently, it is possible to determine the control method and servo gain for the θ-axis direction separately from those for the X-axis direction. This means the θ-axis servomechanical rigidity will be improved, preventing servo control from becoming infeasible due to a rotational error in the slider 11. Additionally, it becomes possible to dramatically improve positioning accuracy for the direction of yawing.
[2] In response to propulsion commands for the X-axis and θ-axis directions, the sum and difference of these propulsion commands are evaluated to generate propulsion commands for the first and second X-axis motors. Consequently, it is possible to give propulsion commands to the two X-axis motors, while at the same time satisfying the conditions under which control tasks for the X-axis and θ-axis directions do not interfere with each other.
[3] The X-axis limits of the propulsion command Ir0 are restricted to Imax - |Irθ| (Imax is the maximum value of the propulsion command). This means the X-axis limits of the propulsion command Ir0 are restricted according to the magnitude of the θ-axis propulsion command Irθ. Consequently, it is possible to give priority to control in the θ-axis direction over control in the X-axis direction. Additionally, control in the θ-axis direction is not affected by control in the X-axis direction and, therefore, can maintain its control characteristics even when the servo control system is under a heavy load or intense acceleration/deceleration.

### (2) Configuration of Motor Cores

FIG. 4 is a schematic view showing an arrangement example of motor cores present in the X-axis and Y-axis motors.

As shown in FIG. 4, teeth 72 and 73 are formed on the cores 70 and 71 of the X-axis motors 14 and 15, at fixed spacings along the X axis. The cores 70 and 71 are arranged symmetrically around the center point O of the slider 11. Likewise, teeth 76 and 77 are formed on the cores 74 and 75 of the Y-axis motor 13, at fixed spacings along the Y axis.

These teeth are arranged so that they are positioned opposite to the teeth of the platen 10.

When the cores 70 and 71 produce propulsion Fx, the slider 11 moves in the direction f. When the core 70 produces propulsion -Fx and the core 71 produces propulsion Fx, the slider 11 rotates in the direction θ1. When the cores 73 and 74 produce propulsion Fy, the slider 11 moves in the direction g.

In this configuration of motor cores, the teeth of the two X-axis motors are arranged symmetrically around the center point of the slider 11. Consequently, the positional errors of the teeth of the two X axes in case of thermal expansion in the slider 11 are almost equal. This means it is possible to reduce the effects of temperature change that motors may suffer.

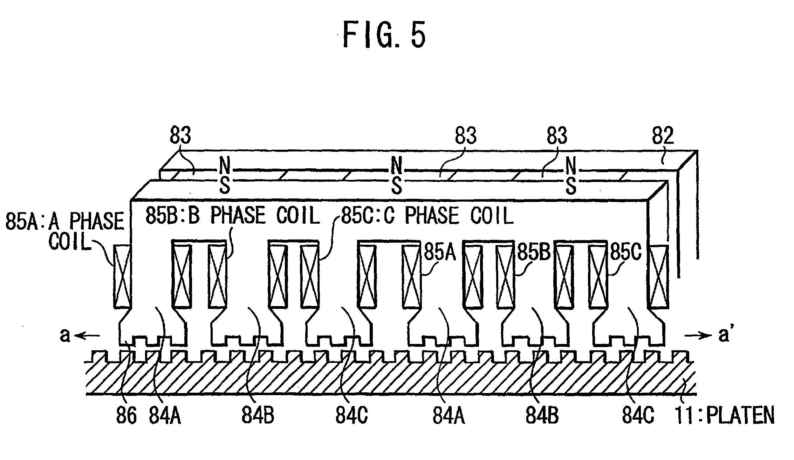

FIG. 5 is a schematic view showing a configuration example of the motor cores present in the X-axis and Y-axis motors.

In FIG. 5, motor cores 81 and 82 are arranged so that they sandwich permanent magnets 83. The permanent magnets 83 are magnetized in the direction in which the motor cores are aligned. The motor core 81 is provided with the windings of phase-A coils 85A, phase-B coils 85B and phase-C coils 85C, in the order in which salient poles 84A, 84B and 84C are arranged. These coils are wound so that they span their respective salient poles of the two motor cores 81 and 82. On the tip of each salient pole, teeth are formed at a pitch P. The teeth of the salient poles 84A, 84B and 84C are given a phase shift of P/3 between each other. Thus, sine-wave currents with a phase shift of 120° between each other are applied to the phase-A coils 84A, phase-B coils 84B and phase-C coils 84C.

The motor core 82 has a configuration similar to that of the motor core 81. The teeth of salient poles on the motor core 82 are arranged so that there is a phase shift of P/2 between them and the teeth of the motor core 81.

The motor cores 81 and 82 move in the a-a' direction when a 3-phase sine-wave current is applied to the phase-A coils 84A, phase-B coils 84B and phase-C coils 84C.

The motor cores shown in FIG. 5 correspond to the single core shown in FIG. 4.

### (3) Configuration of Sensors

### (3-1) First Embodiment of Sensor Configuration

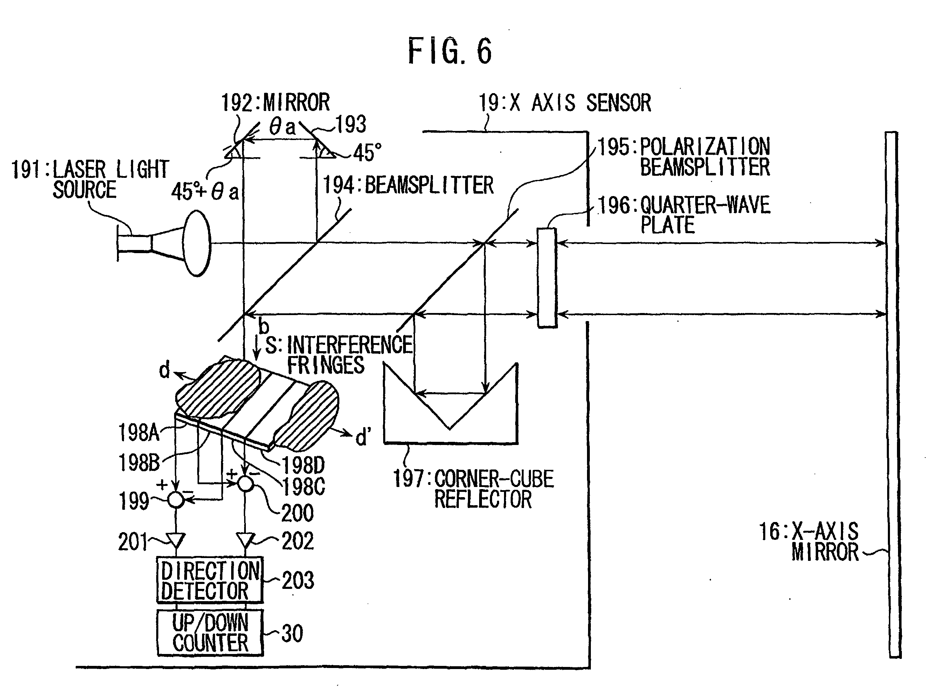

FIG. 6 is a schematic view showing a configuration example of sensors used in the apparatus of FIG. 2. The Y-axis position sensor 18 and X-axis position sensors 19 and 20 in FIG. 2 are all similar in their configurations. The X-axis position sensor 19 is taken as an example here for explanation.

In FIG. 6, a laser light source 191 emits laser light. In the optical path of laser light emitted by the laser light source 191, there are mirrors 192 and 193, a half mirror 194, a polarization beam splitter (abbreviated as PBS) 195, a quarter-wave plate 196, and a corner cube 197.

A light beam, among the light beams that have left the laser light source 191, travels along the half mirror 194, mirror 193, mirror 192, and half mirror 194, thus advancing in the direction b in the figure. Here, this light beam is named light beam ①.

Another light beam, among the light beams that have left the laser light source 191, travels along the half mirror 194, PBS 195, quarter-wave plate 196, X-axis mirror 16, quarter-wave plate 196, PBS 195, corner cube 197, quarter-wave plate 196, X-axis mirror 16, quarter-wave plate 196, PBS 195, and half mirror 194, thus also advancing in the direction b in the figure. Here, this light beam is named light beam ②.

The mirror 193 is arranged so that it is at an angle of 45° to the optical axis of the laser light source 191. In contrast, the half mirror 194 is arranged so that it is at an angle of 45° + θa to the optical axis. The angle difference θa of the half mirror 194 causes the wavefront of the light beam ① to differ from that of the light beam ② by as much as θa.

Consequently, the light beams ① and ② interfere with each other to form interference fringes S. A photodiode array (abbreviated as PDA) 198 detects the interference fringes S. The PDA 198 consists of four photodiodes 198A to 198D. The four photodiodes 198A to 198D are placed within a single pitch of the interference fringes S. The photodiodes 198A to 198D are arranged at an equal spacing of p/4 (p is the pitch of the interference fringes).

The following relationship holds true in this case:$\text{Pitch p of interference fringes = λ/θa (λ is the wavelength} \text{of laser light)}$

A subtractor 199 makes a calculation represented as "(signal detected by photodiode 198A) - (signal detected by photodiode 198C)."

Similarly, a subtractor 200 makes a calculation represented as "(signal detected by photodiode 198B) - (signal detected by photodiode 198D)."

The X-axis position sensor 19 moves as the slider 11 moves, causing the interference fringes to move in the d-d' direction shown in FIG. 6. The light and dark bands of the interference fringes exposed to each of the photodiodes 198A to 198D also move as the interference fringes move, thus causing the values detected by the photodiode 198A to 198D to change. The position of the slider 11 is detected according to these changes.

If the interference fringes move in the direction d, the outputs VA to VD of the photodiodes are as follows:$\text{VA = K[1 + msin{xe·2π/(λ/4)}] + Kn}$$\text{VB = K[1 + mcos{xe·2π/(λ/4)}] + Kn}$$\text{VC = K[1 - msin{xe·2π/(λ/4)}] + Kn}$$\text{VD = K[1 - mcos{xe·2π/(λ/4)}] + Kn}$ where
xe is the distance of object being detected;
K and m are coefficients; and
Kn is a noise component.

The signals of the subtractors 199 and 200 are as follows:$\text{VA - VC = 2mKsin{xe·2π/(λ/4)}}$$\text{VB - VD = 2mKcos{xe·2π/(λ/4)}}$

As the result of subtraction, the dc noise component Kn that occurs due to disturbing light is cancelled.

The signals VA - VC and VB - VD are converted to the phase-A and phase-B pulses mentioned above.

If the interference fringes move in the direction d', the phase relationship between the signals VA- VC and VB - VD is reversed.

Comparators 201 and 202 generate the phase-A and phase-B pulses from the subtraction signals of the subtractors 199 and 200.

From the phase relationship between the phase-A and phase-B pulses, a direction detector 203 identifies the direction in which the slider 11 moves, in order to generate count-up or count-down pulses depending on the result of identification.

The up-down counter 30 counts up or down according to the generated count-up or count-down pulses. The count of the up-down counter 30 represents the position detected by the slider 11.

It is previously known how much the phases of teeth on the rotor and stator of the X-axis motor 14 will shift under the initial condition when a known current is applied to each coil having a different phase. The value of the up-down counter 30 at this point is set to 0, for example, as a reference value. The up-down counter 30 counts up or down from the reference value as the slider 11 moves, thus detecting the position of the slider 11. Thus, the position of the slider 11 is detected in an incremental manner.

### (3-2) Second Embodiment of Sensor Configuration

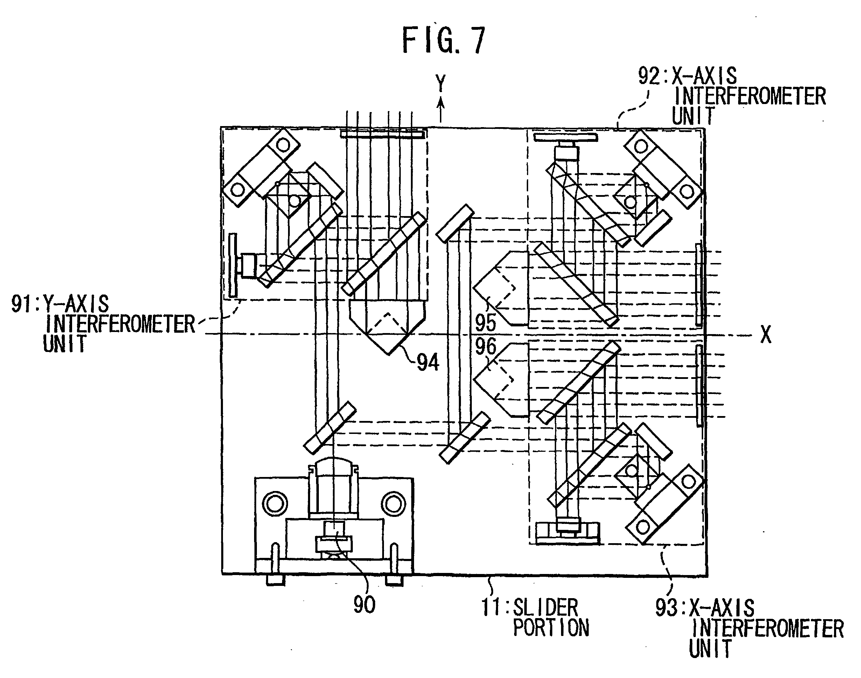

FIG. 7 is a schematic view showing another configuration example of sensors used in the apparatus of FIG. 2.

In FIG. 7, a laser light source 90 is common to the Y-axis position sensor 18 and X-axis position sensors 19 and 20. A Y-axis interferometer unit 91 and X-axis interferometer units 92 and 93 are units that compose the Y-axis position sensor 18 and X-axis position sensors 19 and 20, respectively. The Y-axis interferometer unit 91 and X-axis interferometer units 92 and 93 emit laser light in the Y-axis and X-axis directions, respectively. Then, they find positions optically by receiving light beams reflected by the Y-axis mirror 17 and X-axis mirror 16.

The Y-axis position sensor 18 and X-axis position sensors 19 and 20 are provided with corner cubes 94, 95 and 96, respectively.

The corner cube 94 of the Y-axis position sensor 18 is positioned at the Y-axis center point of the slider 11. The corner cubes 95 and 96 of the X-axis position sensors 19 and 20 are arranged symmetrically around the X-axis center line of the slider 11.

This arrangement of corner cubes results in the condition that the positional errors of these corner cubes in case of thermal expansion in the slider 11 are almost equal. This means it is possible to reduce the effects of thermal expansion that sensors may suffer.

### (3-3) Third Embodiment of Sensor Configuration

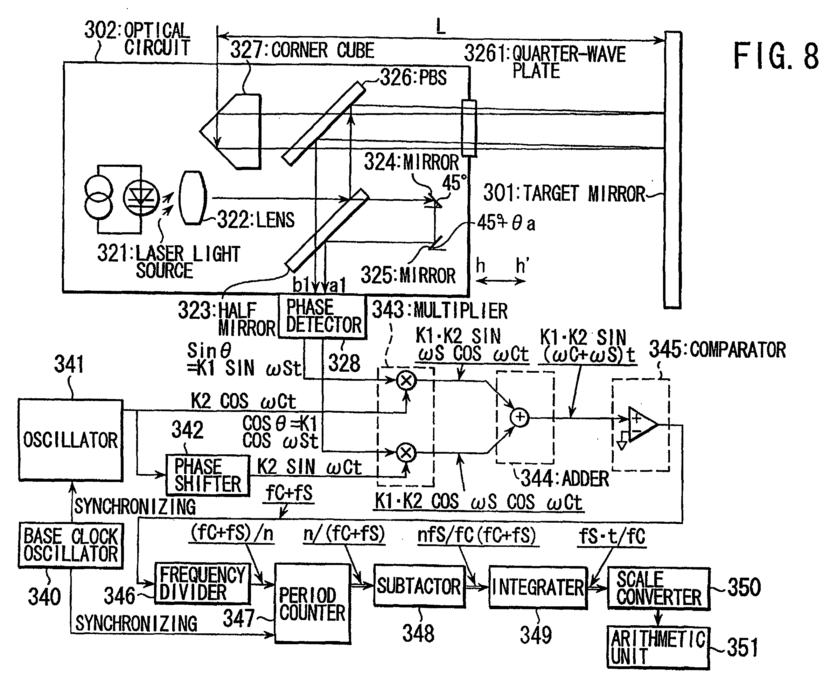

FIG. 8 is a schematic view showing yet another configuration example of the sensors used in the apparatus of FIG. 2.

In FIG. 8, a target mirror 301 is fixed and an optical circuit 302 moves in the h-h' direction along with the object being detected (not shown in the figure).

A laser light source 321 emits laser light having a polarimetric component perpendicular to the plane of the sheet of paper. A lens 322 changes the beams of the laser light source 321 to parallel beams. A half mirror 323 separates light beams that have passed through the lens 322, into transmitted and reflected light beams.

Fixed mirrors 324 and 325 receive the transmitted light beam from the half mirror 323 and reflect it back to the half mirror 323. The mirror 324 is arranged at an angle of 45° to the optical axis of the laser light source 321. In contrast, the mirror 325 is arranged at an angle of 45° + θa to the optical axis.

A polarization beam splitter (abbreviated as PBS) 326 reflects back the light beam that is reflected by the half mirror 323. The reflected light beam passes through a quarter-wave plate 3261 and advances to the target mirror 301.

As a light beam passes through the quarter-wave plate 3261 twice, it is changed from vertically polarized light to a horizontally polarized light, and then vice versa.

Use of the quarter-wave plate 3261 allows for selection from transmitted and reflected light beams with the PBS 326.

The corner cube 327 reflects the light that has been. reflected by the target mirror 301 and then transmitted through the quarter-wave plate 3261 and PBS 326, to let it go back to the PBS 326.

A phase detector 328 detects interference fringes produced by the light that has returned to the half mirror 323.

Here, the distance between the target mirror 301 and the corner cube 327 is assumed to be L.

In the position sensor of FIG. 8, some light beams, among those emitted by the laser light source 321, follow the paths shown below.

Lens 322 → half mirror 323 → mirror 324 → mirror 325 → half mirror 323 → phase detector 328

A light beam that follows this path is named here as light beam ①.

Lens 322 → half mirror 323 → PBS 326 → quarter-wave plate 3261 → target mirror 301 → quarter-wave plate 3261 → PBS 326 → corner cube 327 → PBS 326 → quarter-wave plate 3261 → target mirror 301 → quarter-wave plate 3261 → PBS 326 → half mirror 323 → phase detector 328

A light beam that follows this path is named here as light beam ②.

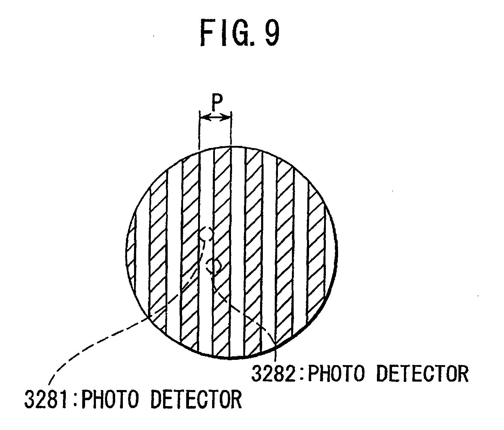

The angle at which the mirror 325 is positioned is shifted by as much as θa from that of the mirror 324. Therefore, the wavefront of a light beam **a** that has returned after following the path of the light beam ① also shifts by as much as θa from that of a light beam **b** that has returned after following the path of the light beam ②. This wavefront shift causes light beams **a1** and **b1** to interfere with each other to produce interference fringes S. A pattern of the interference fringes S is shown in FIG. 9. The pitch P of the interference fringes S is given by the following formula:$\text{P = λ/θa (λ is the wavelength of laser light)}$

The phase detector 328 detects interference fringes by means of a pair of photodetectors that are arranged, with a phase shift of as much as P/4 pitch from each other, in the direction in which the interference fringes are aligned. These photodetectors, for example, are photodiodes. FIG. 9 shows how the two photodetectors 3281 and 3282 are arranged.

The two photodetector 3281 and 3282 output signals corresponding to the amount of light they receive.

Signals detected by the photodetectors 3281 and 3282 are represented as K1sinθ and K1cosθ (K1 is a constant and θ is a phase), respectively.

The phase θ is modulated according to the amount of movement ΔL that the optical circuit 302 makes. θ is given by the following formula:$\text{θ = 2π·4ΔL/λ}$

The reason for the number "4" being present in formula (1) is because a light beam makes two round trips between the target mirror 1 and the corner cube 327; therefore, the optical length changes by as much as 4ΔL when the optical circuit 2 moves by as much as ΔL.

From formula (1), the amount of movement ΔL is given by the following equation:$\text{ΔL = θλ/8π}$

For easier explanation, it is assumed that the optical circuit 302 moves at a constant speed of V along with the object being detected.

The phase detector 328 outputs the signals K1sinθ and K1cosθ. Since the optical circuit 302 moves at a constant speed, K1sinθ = K1sinωst and K1cosθ = K1cosωst (ωs is an angular frequency and t is time) hold true. Under the above-mentioned conditions, ΔL = Vt holds true. From equation (1), the following equation is obtained:$\text{θ = 2π·4ΔL/λ} \text{= 2π·4Vt/λ} \text{= 8π·Vt/λ}$ Since θ = ωst, the following equation holds true:$\text{ωs = 8π·V/λ}$ Assuming ωs = 2πfs (fs is frequency), then$\text{fs = 4V/λ}$

A base clock oscillator 340 generates a base clock signal whose frequency is sufficiently higher than a frequency fc.

An oscillator 341 generates the signal K2cosωct (K2 is a constant; ωc >> ωs) from the base clock.

A phase shifter 342 shifts the phase of the signal K2cosωct, thereby producing the signal K2sinωct.

A multiplier 343 multiplies the modulated signals K1sinωst and K1cosωst by the reference signals K2cosωct and K2sinωct, respectively.

An adder 344 adds the two multiplication signals to obtain the signal K1·K2sin(ωc + ωs)t.

A comparator 345 converts the addition signal to a pulse signal.

A frequency divider 346 divides the frequency of the pulse signal by a dividing ratio of **n** (**n** is an integer). Thus, the frequency divider 346 provides the signal whose frequency is (fc + fs)/n (ωc = 2πfc).

A period counter 347 measures the period n/(fs + fc) of the frequency-divided signal received from the frequency divider 346, using the base clock. Since the frequency of the base clock is sufficiently high compared with (fc + fs)/n, it is possible to measure the period with high resolution. It should be noted that the period may be measured using a clock other than the base clock. Any measuring clock is acceptable as long as the period thereof is sufficiently short compared with the period n/(fs + fc) of the frequency-divided signal.

A subtractor 348 finds the difference between the period n/fc of the reference signal and the measured period n/(fs + fc) of the period counter 347. This provides the period difference of nfs/fc(fs + fc).

An integrator 349 integrates the period difference nfs/fc(fs + fc) of the subtractor 348 at intervals of n/(fs + fc). This provides the integral value fst/fc.

A scale converter 350 multiplies the integral value fst/fc by λfc/4 to calculate the travel distance ΔL. From equation (3), this calculation is made as shown below:$\text{fst/fc × λfc/4} \text{= 4V/λ × t/fc × λfc/4} \text{= Vt} \text{= ΔL}$ Thus, the travel distance ΔL can be determined.

An arithmetic unit 351 calculates the position of an object being detected from the travel distance ΔL.

The position calculation means referred to in the "What Is Claimed Is" section corresponds to the scale converter 350 and arithmetic unit 351.

The direction in which the object being detected moves varies as the polarity of ωs changes depending on the phase lead/lag relationship between the two modulated signals K1sinωst and K1cosωst; therefore, the direction is determined by judging whether the frequency fs + fc is higher or lower than fc.

It should be noted that the sensors may be configured in such a manner that 1) the multiplier 343 multiplies the modulated signals K1sinωst and K1cosωst by the reference signals K2sinωct and K2cosωct, respectively, and 2) the adder 344 adds the two multiplication signals, thereby obtaining the signal K1·K2cos(ωc - ωs)t.

Although in this embodiment an explanation has been made of the case wherein the optical circuit 302 moves, the target mirror may be made to move and the optical circuit 302 may be fixed instead.

According to the sensor configuration of FIG. 8, the following advantages are offered.
[1] Two signals that have been modulated according to the travel distance of an object being detected are multiplied by their respective reference signals generated from the base clock. Then, the two multiplication signals are added to produce a signal whose frequency is sufficiently high compared with those of the modulated signals. This means the high-frequency signal is also input to a comparator for pulsing the addition signal, when the object being detected is at a stop or moving at low speed. Consequently, the comparator need not have any hysteresis. The absence of hysteresis ensures that the position sensor does not malfunction even if the amplitude of a comparator input varies.
[2] An arithmetic process is applied to a signal obtained from a phase detector to convert the signal to a high-frequency signal, before the initial signal is input to the comparator. This means the high-frequency signal is also input to the comparator when the object being detected is at a stop or moving at low speed. Consequently, the comparator need not have any hysteresis. The absence of hysteresis ensures that the position sensor does not malfunction even if the amplitude of a comparator input varies. Additionally, since the signal of a phase detector is divided before the signal's period is measured, the position sensor is immune to effects of duty-cycle distortion in the comparator. Consequently, the position sensor can hardly malfunction even if the phase detector's output changes suddenly.
[3] Signals, which are modulated in terms of their periods according to the travel distance of an object being detected, are generated. Then, the periods of the modulated signals are measured using a measuring clock whose period is sufficiently short compared with those periods, thus detecting the object's position. This means the position can be detected with high accuracy.
[4] The base clock is designed for common use by the phase detector and period counter to generate a signal, by which the phase detector's output is multiplied, and a measuring clock for the period counter. Consequently, it is possible to accurately synchronize the phase detector's output with the timing of period measurement.

### (4) Configuration of Motor Drive Circuit

### (4-1) First Embodiment of Motor Drive Circuit Configuration

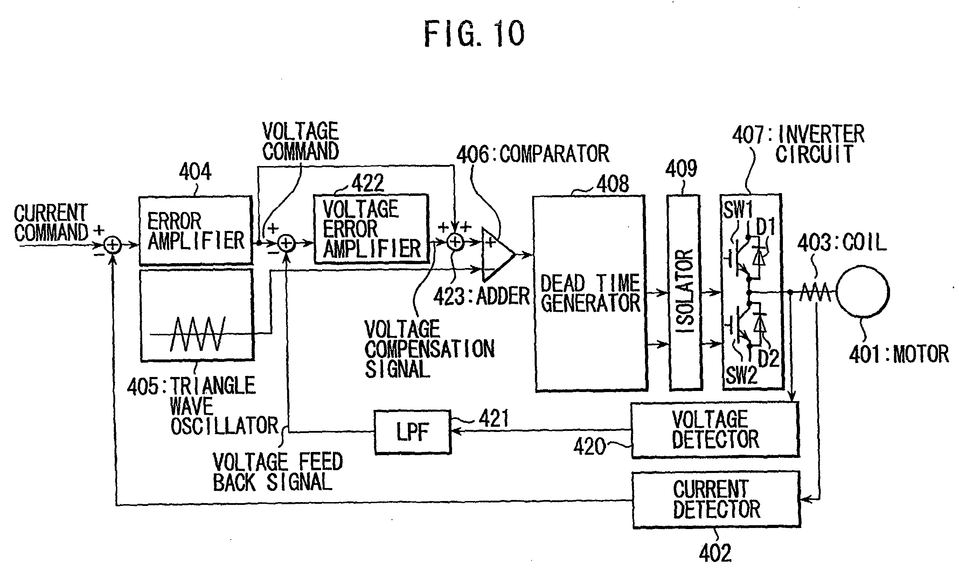

FIG. 10 is a schematic diagram showing a configuration example of a motor drive circuit used in the apparatus of FIG. 2.

In FIG. 10, a motor 401 is, for example, a pulse motor.

An current detector 402 detects the magnitude of an electric current flowing through the coil 403 of the motor 401, in an electrically isolated manner, to feed back the detected signal.

A current error amplifier 404 calculates and amplifies the difference between a current command given by a control command and an electric current detected by a current detector 2. Thus, the current error amplifier 404 outputs the amplified signal as a voltage command. The calculation mentioned above is, for example, integration.

A triangular-wave oscillator 405 generates a triangular-wave signal for producing a PWM signal (pulse-width modulated signal).

A comparator 406 compares the voltage command signal of the current error amplifier 404 with the triangular-wave signal of the triangular-wave oscillator 405 to generate a PWM signal.

A bridge-type inverter circuit 407 comprises two switches SW1 and SW2 connected in series, the connection point thereof being connected to the coil 403 of a motor 401 to electrify the coil 403 by turning on and off the switches SW1 and SW2. The switches SW1 and SW2 consist, for example, of transistors. Diodes D1 and D2 are connected in parallel to the switches SW1 and SW2.

A dead-time generator 408 generates a switch control signal for turning on and off the switches SW1 and SW2 from a PWM signal supplied by a comparator 6.

At this point, a dead time is set in the switch control signal to prevent the switches SW1 and SW2 from turning on simultaneously. If the switches SW1 and SW2 turn on simultaneously, a large current will flow through the switches, possibly burning them out.

An isolator 409 is provided in order to isolate the inverter circuit 407 from the dead-time generator 408.

The PWM signal output by the dead-time generator 408 is transmitted to the inverter circuit 407 in an electrically isolated manner. The switches SW1 and SW2 are turned on and off by the transmitted PWM signal, thus causing an electric current to flow through the coil 403.

The output voltage of the inverter circuit 407 is a rectangular-wave signal and the voltage's mean value is proportional to the output of the current error amplifier 404.

The output voltage of the inverter circuit 407 turns on an electric current through the motor 401 and an electric current feedback signal is obtained by means of the current detector 402 to form a feedback loop and thereby a constant-current loop.

A voltage detector 420 detects the output voltage of the inverter circuit 407 and is, for example, an electrically isolated voltage detector.

An LPF (low-pass filter) 421 cuts off PWM noise contained in the output of the voltage detector 420 included to obtain a voltage feedback signal.

A voltage error amplifier 422 amplifies the difference between a voltage command given by the voltage command signal of the current error amplifier 404 and a voltage value detected by the voltage detector 420. Thus, the voltage error amplifier 422 outputs the amplified signal as a voltage compensation signal.

An adder 423 adds the voltage compensation signal to the voltage command signal to compensate the voltage command signal. Then, the adder 423 feeds the compensated voltage command signal to the comparator 406. The addition signal is compared with a triangular-wave signal of the triangular-wave oscillator 405 to generate a PWM signal.

In the circuit of FIG. 10, the output voltage of the inverter circuit 407 is fed back, a voltage compensation signal is produced from the signal thus fed back, and a voltage command signal is compensated by the voltage compensation signal. Consequently, it is possible to reduce errors that may occur due to a deadband in the output voltage of the inverter circuit 407 when the direction of electric current is changed.

### (4-2) Second Embodiment of Motor Drive Circuit Configuration

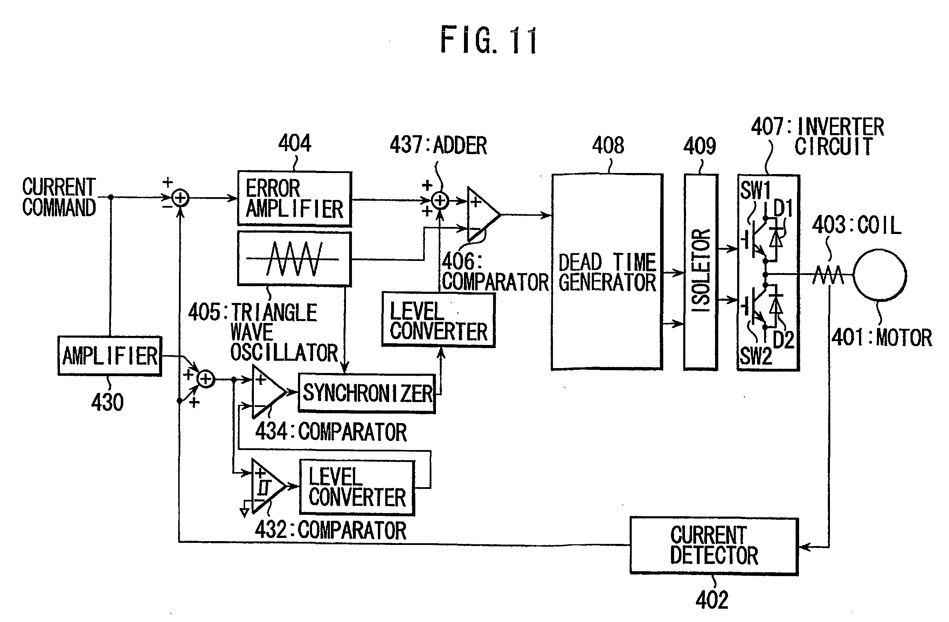

FIG. 11 is a schematic diagram showing another configuration example of the motor drive circuit used in the apparatus of FIG. 2.

An amplifier 430 amplifies a current command signal given by the control command.

An adder 431 adds the amplified signal of the amplifier 430 and the current feedback signal of the current detector 402 to produce a monitor signal. This addition is performed to take an average of the two signals.

A comparator 432 compares the level of the monitor signal with a given reference value to detect the direction (polarity) of electric current. The comparator 432 is a hysteresis-based comparator.

A level converter 433 sets the output of the comparator 432 to a level for detecting a zero-cross point corresponding to the direction of electric current.

A comparator 434 compares the level of the monitor signal with the level set by the level converter 433 to detect a zero-cross point corresponding to the direction of electric current. The direction of electric current referred to here is either the case when the current changes from the positive to negative polarity or the case when the current changes from the negative to positive polarity.

A synchronizer 435 synchronizes the output of the comparator 434 with the triangular-wave signal of the triangular-wave oscillator 405. The synchronizer 435 is composed of flip-flops.

Since the current feedback signal output by the current detector 402 has a lag against the control command, the monitor signal has a phase lead against an actual electric current of the coil 403. This phase lead is determined by the gain of the amplifier 430. The gain of the amplifier 430 is adjusted properly to produce the optimum timing for compensating a deadband near a zero-cross point.

Additionally, the reference input with which the compensation of a deadband near a zero-cross point begins is adjusted to the optimum level by adjusting the level of the level converter 433.

The output of the comparator 434 is synchronized with a triangular-wave signal by the synchronizer 435, and then input to the level converter 436. The level converter 436 is set to a level for compensating the output voltage of the inverter circuit 407 near a zero-cross point. Thus, the level converter 436 produces a signal adjusted so as to compensate a change in the duty ratio of the output signal of the inverter circuit 407.

An adder 437 adds the output signal of the level converter 436 to the voltage command signal of the current error amplifier 404 to compensate the voltage command. Consequently, any change in the duty ratio of the output signal of the inverter circuit 407 is cancelled and, therefore, any dead-time distortion is compensated.

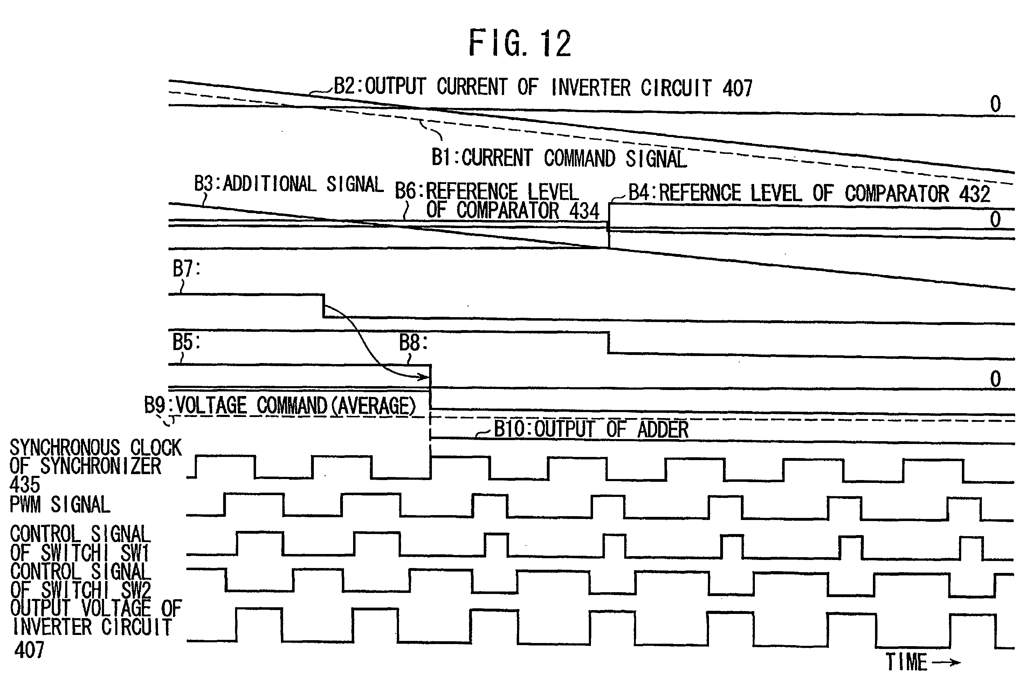

FIG. 12 is a timing chart showing the relationship among signals in the circuit diagram of FIG. 11.

A current command signal B1 and the output current B2 of the inverter circuit 407 are added to produce an addition signal B3. The addition signal B3 is input into the comparators 432 and 434.

Since the comparator 432 has hysteresis, a reference level B4 changes when the addition signal B3 becomes lower than the reference level B4. At this point the output B5 of the comparator 432 changes.

The output B5 of the comparator 432 is changed to a different level by the level converter 433 to be given as a reference level B6 to the comparator 434.

When the addition signal B3 becomes lower than the reference level B6, the output B7 of the comparator 434 changes. The output B7 of the comparator 434 is synchronized with the synchronization clock of the synchronizer 435. Then, the level of the output B7 is changed by the level converter 436 to become an output B8. The average of the voltage command is negative, as indicated by a symbol B9. The output B8 and voltage command B9 are added by an adder 437, and the output B10 thereof is given to the comparator 406 after correction.

The pulse width of a PWM signal shortens after the post-correction output B10 has risen. Consequently, a deadband near a zero-cross point in the output current of the inverter circuit 407 is cancelled.

It should be noted that the motor 401 may be a direct drive motor or a linear motor.

The motor 401 may also be a motor for moving the slider of the two-dimensional positioning apparatus in which the slider is levitated by means of air bearings.

According to the motor drive circuits of FIGS. 10 and 11, a voltage command is compensated near the zero-cross point of the output current of the inverter circuit 407. Consequently, it is possible to eliminate any deadband near the zero-cross point of the output current of the inverter circuit 407 and thereby improve the controllability of electric current flowing through motor coils.

### (5) Configuration of Means for Measuring Laser Light Wavelengths

In the position sensor of the apparatus in FIG. 2, position measurement is performed by means of laser light interference. The wavelength of laser light can change due to, for example, aging. Means for measuring laser light wavelengths is therefore provided in the apparatus in order to detect such a change.

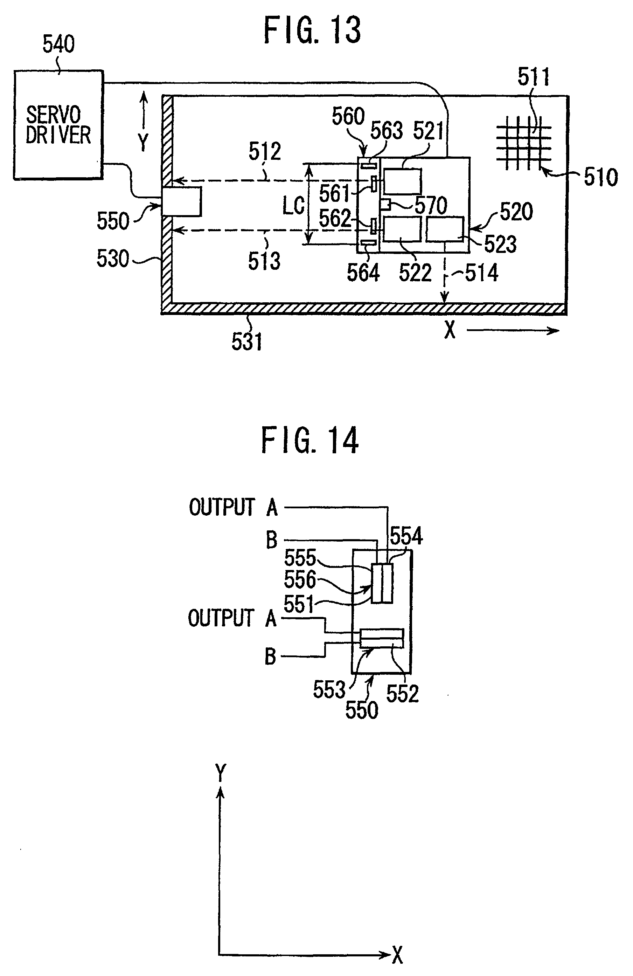

FIG. 13 is a schematic view showing a configuration example of a two-dimensional positioning apparatus provided with means for measuring laser light wavelengths.

As shown in FIG. 13, the two-dimensional positioning apparatus comprises:
a platen 510 which is made of magnetic iron plates and on which teeth 511 are formed at fixed pitches in a lattice pattern;
a slider 520 which can move above the platen 510 in the X-axis and Y-axis directions;
an X-axis mirror 530 consisting of mirrors located at the end of the X axis to reflect laser lights 512 and 513;
a Y-axis mirror 531 consisting of a mirror located at the end of the Y axis to reflect a laser light 514;
a origin sensor 550 located in a given position at the end of the X axis; and
a servo driver (motor drive unit) 540 for driving and controlling the slider 520 in the X-axis and Y-axis directions.

The slider 520 comprises means for levitating the slider 520 by means of an air bearings mechanism (not shown in the figure); rotors consisting of cores and coils for moving the slider 520 in the X-axis and Y-axis directions by means of magnetic attraction (not shown in the figure); and a slit temperature sensor 570 for detecting the temperature of a return-to-origin slit plate 560.

The upper section of the slider 520 comprises X1-axis and X2-axis laser interferometers 521 and 522 for emitting the laser light 512 and 513 onto the X-axis mirror 530 to detect the X-axis position by means of the interference between catoptric light beams from the X-axis mirror 530; a Y-axis laser interferometer 523 for emitting the laser light 514 onto the Y-axis mirror 531 to detect the Y-axis position by means of the interference between catoptric light beams from the Y-axis mirror 531; and a return-to-origin slit plate 560 located on the X axis of the slider 520. The X1-axis and X2-axis laser interferometers 521 and 522 are arranged at a given spacing so as to detect the yaw angle (rotational angle θ around the Z axis) of the slider 520.

The return-to-origin slit plate 560 is formed using glass slits and comprises two X1 and X2 slits 561 and 562 separately aligned in series in the Y-axis direction; a Y slit 563 positioned external and perpendicular to the X1 slit 561; and a wavelength-calibrating C slit 564 positioned external and perpendicular to the X2 slit 562. The wavelength-calibrating C slit 564 is formed so as to be parallel and share the same width with the Y slit 563. The Y slit 563 and wavelength-calibrating C slit 564 compose the means for detecting laser wavelengths.

As shown in FIG. 14, the origin sensor 550 comprises a light emitter for emitting light consisting of laser lights; a Y-axis photodetector 553 consisting of two photodetectors 551 and 552 arranged at a given spacing; and an X-axis photodetector 556 consisting of two photodetectors 554 and 555 arranged in the direction perpendicular to the Y-axis photodetector 553.

In the configuration discussed above, the slider 520 can move above the platen 510 by means of magnetic attraction. Additionally, the servo driver 540 connected to the slider 520 performs positioning control using position signals provided by the X1-axis and X2-axis laser interferometers 521 and 522 and Y-axis laser interferometer 523 on the slider 520. More specifically, the servo driver 540 controls the X-axis position and the rotational angle θ of the slider 520 provided by the interference between catoptric light beams 512 and 513 from the X1-axis and X2-axis laser interferometers 521 and 522 fixed onto the slider 520, and detects the Y-axis position provided by the interference between the catoptric beams of the laser light 514 emitted by the Y-axis laser interferometer 523. Additionally, the return-to-origin slit plate 560 located on the X axis of the slider 520 is aligned with the origin sensor 550 located at the X-axis end of the platen 510 in order to cause return-to-origin action in the X-axis, Y-axis and θ-axis directions.

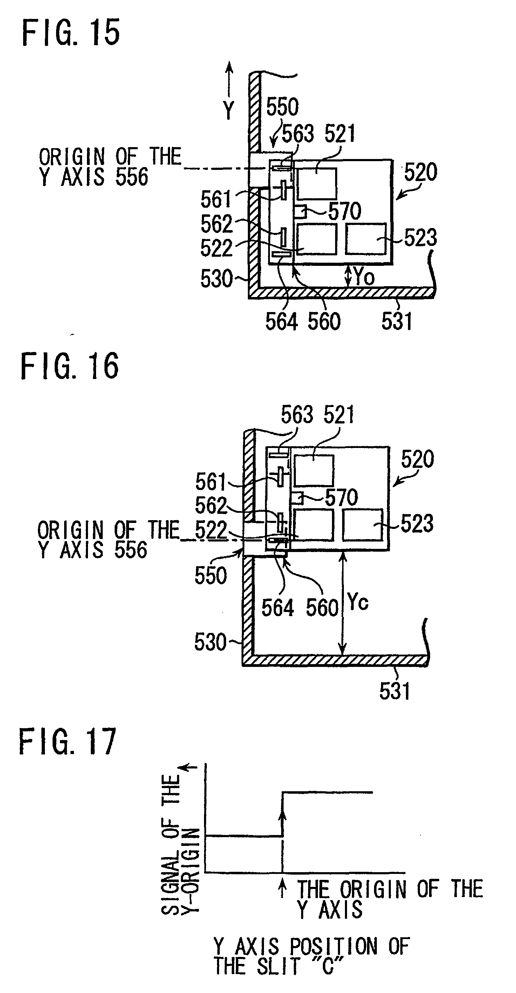

In the first step of the return-to-origin action, the on-off state of a Y-axis origin signal changes, as shown in FIG. 17, when as shown in FIG. 15, the Y slit 563 reaches the Y-axis origin position where the Y-axis photodetector 553 of the origin sensor 550 is located. This enables the servo driver 540 to place the slider 520 in a Y-axis position where the Y slit 563 agrees with the Y-axis origin position. The coefficient (number of detected interference fringes), which is provided at this point by the interference between the catoptric beams of the laser light 514 emitted by the Y-axis laser interferometer 523 and indicates the detected Y-axis position, is assumed to be Yo. In the second step, the slider 520 is moved in parallel with the X-axis mirror 530 to position the slider 520 so that the C slit 564 agrees with the Y-axis origin position. The coefficient (number of detected interference fringes), which is provided at this point by the interference between the catoptric beams of the laser light 514 emitted by the Y-axis laser interferometer 523 and indicates the detected Y-axis position, is assumed to be Yc. The wavelength λn of a laser light at this point can be determined by the following equation:$\text{λn = K·Lc/(Yc - Yo)}$ where, K is a design-dependent constant and Lc is the distance between the Y and C slits that is measured during production and set in the servo driver 540. Equation (4) is the means for measuring the wavelength of the laser light 514 from the interference between the catoptric beams of the laser light 514, where the interference occurs at the origin position that is detected by each of the two slits (Y and C slits 563 and 564) using the same photodetector (Y origin position (556) of the origin sensor 550).

As explained above, position detection based on the Y and C slits 563 and 564 using the same origin sensor 550 is performed by moving the slider 520 in the Y-axis direction, thus calculating the distance-related coefficients Yo and Yc. Then, the laser light wavelength λn is calculated according to equation (4) so that deterioration in the laser light can be measured each time return-to-origin action takes place. By measuring the laser light wavelength in this configuration, it is possible to achieve laser light detection at lower cost and maintain high positioning accuracy even if a change due to aging occurs in the laser light. Additionally, it is also possible to warn the user at an early stage, for example, in the event that an interferometer becomes defective as the result of a significant change in the laser light wavelength. Furthermore, in an environment where temperature and atmospheric pressure changes are moderate, the need for correcting the refractive index may be eliminated by automatically correcting the wavelength at proper time intervals. In other words, any temperature and atmospheric pressure sensors will become unnecessary, resulting in cost reductions.

It should be noted here that the return-to-origin slit plate 560 expands or contracts slightly depending on the temperature. The length of expansion or contraction can be corrected, however, using the temperature detected by the slit temperature sensor and therefore can be taken into account. For example, assuming the temperature error ΔT = ±1°C, Lc = 150 mm, the linear expansion factor of the return-to-origin slit plate 560 is 0.5 × 10⁻⁶, the error included in Lc is${\text{0.15 (m) × 0.5 × 10}}^{\text{-6}} {\text{× 1 = 0.075 × 10}}^{\text{-6}}$

Assuming the reproduction accuracy of the origin signal of the origin sensor 550 is ±0.1 µm, the temperature error occurring in (Yc-Yo) is ±0.2 µm. Therefore, the accuracy with which the laser light wavelength λn is detected is approximately${\text{(0.075 × 10}}^{\text{-6}} {\text{+ 0.2 × 10}}^{\text{-6}} \text{)/0.15} {\text{= 1.8 × 10}}^{\text{-6}} \text{= 1.8 ppm}$ This means the position detection error occurring when the distance of the X1-axis and X2-axis laser interferometers 521 and 522 from the X-axis mirror 530 is 1 m is kept to approximately 2 µm.

As explained above, the distance of the C slit 564 from the Y slit 563 can be made as long as possible in this embodiment, while maintaining the positional relationship between the Y and C slits 563 and 564 to be the same. Consequently, it becomes possible to detect deterioration in the laser light of a laser interferometer at an early stage by simply measuring an error between the detection accuracy of the Y slit 563 and that of the wavelength-calibrating C slit 564.

According to the two-dimensional positioning apparatus of FIG. 13, the two slits at the moment of returning to the origin are used to measure the wavelength of laser light from the difference in the interference between the catoptric beams of laser light that is emitted from different positions of the slider 520. Consequently, the apparatus is advantageous in that it is possible to detect deterioration in laser light due to aging at an early stage and maintain the high accuracy of slider positioning.

## Claims

1. A two-dimensional positioning apparatus for positioning an object in a two-dimensional direction, comprising:
a platen (10) whereon teeth (101) are formed at fixed spacings along X and Y axes;
a slider (11) provided with two X-axis motors (14, 15), two X-axis position sensors (19,20), a Y-axis motor (13) and a Y-axis position sensor (18), said slider (11) being loaded with said object and levitated above said platen (10);
a converter (36) for producing signals for detecting a X-axis position of said slider's center point and a yaw angle θ of said slider according to the position detection signals of said two X-axis position sensors (19, 20);
an Xθ controller (40) for feedback-controlling the movement of said slider (11) in the X-axis and θ-axis directions separately according to signals converted by said converter (36);
a command converting circuit (42) for converting the control output of said Xθ controller (40) to propulsion commands to be given to said two X-axis motors (14, 15); and
a Y-axis controller (21) for receiving the position detection signal of said Y-axis position sensor (18) and feedback-controlling the Y-axis direction according to said position detection signal.

2. The two-dimensional positioning apparatus according to claim 1, comprising:
levitating means (12) for levitating said slider (11) above said platen (10);
said converter (36) receiving the position detection signals of said first and second X-axis position sensors (19, 20) and producing a signal for detecting the X-axis position of said slider's center point according to the sum of said position detection signals, and producing a signal for detecting the yaw angle θ of said slider (11) according to the difference between said position detection signals.

3. The two-dimensional positioning apparatus of claim 2, wherein said command converting circuit (42) receives X-axis and θ-axis propulsion commands output by said Xθ controller (40) to produce propulsion commands ,to be given to said two X-axis motors (14, 15) according to the sum of and difference between said X-axis and θ-axis propulsion commands.

4. The two-dimensional positioning apparatus of claim 2, further comprising a limiter for restricting the X-axis limits of the propulsion command Ir0 to Imax -|Ire|, Imax being the maximum value of the propulsion command and Ire being a θ-axis propulsion command, and thereby restricting the limits of the propulsion command Ir0 according to the magnitude of the θ-axis propulsion command Ire.

5. The two-dimensional positioning apparatus of claim 2, wherein said first and second X-axis motors (14, 15) have cores whereon teeth are formed opposite to the teeth (101) of said platen (10) at fixed spacings along the X axis, the cores of said first and second Xaxis motors (14, 15) being arranged symmetrically around the center point of said slider (11).

6. The two-dimensional positioning apparatus of claim 2, wherein said Y-axis position sensor (18) and said first and second X-axis position sensors (19, 20) optically detect position using laser interferometers and are provided with corner cubes, the corner cube of said Y-axis position sensor being arranged at the center point of the Y axis and the corner cubes of said first and second X-axis position sensors being arranged symmetrically around the X-axis center line of said slider (11).

7. The two-dimensional positioning apparatus according to claim 1 or 2, comprising:
an optical circuit for producing interference fringes with a fixed pitch, by means of optical interference, that move as an object being detected moves; and
at least one position sensor (18, 19, 20) having a phase detector for detecting interference fringes by means of a plurality of photo-detectors arranged at a given spacing in the direction in which the interference fringes are aligned and producing two modulated signals that are modulated according to the amount of movement made by said object,
wherein said two-dimensional positioning apparatus further comprises:
a multiplier for multiplying said two modulated signals by reference signals generated from a base clock; and
an adder for adding said two multiplication signals.

8. The two-dimensional positioning apparatus according to claim 1 or 2, wherein said position sensors (18, 19, 20) use interferometers, comprising:
an optical circuit for producing interference fringes with a pitch P, by means of optical interference, that move as said object moves;
a phase detector for detecting interference fringes by means of a plurality of photodetectors that are arranged with a phase shift of as much as P/4 pitch from each other, in the direction in which the interference fringes are aligned, and producing the modulated signals K1sinωst and K1cosωst (K1 is a constant and t is time), whose angular frequency ωs is modulated according to the amount of movement made by said object, from signals detected by said plurality of photodetectors;
a multiplier for multiplying said modulated signals K1sinrost and K1cosωst by the reference signals K2cosωct and K2sinωct (ωc >> ωs), respectively, that are generated from a base clock;
an adder for adding said two multiplication signals to obtain the signal K1-K2sin(ωc + ωs}t;
a comparator for converting said addition signal to a pulse signal;
a frequency divider for dividing said pulse signal with a dividing ratio of n (n is an integer);
a period counter for measuring the period n/(fs + fc} {ωc = 2Jtfc and ωs = 2Jtfs} of a frequency-divided signal obtained from said frequency divider by using a clock which is synchronized with said base clock and whose period is sufficiently short compared with the period of said frequency-divided signal;
a subtractor for finding the difference between the measured period of said period counter and the period nlfc of a reference signal;
an integrator for integrating the period difference of said subtractor at intervals of n/(fs + fc}; and
position calculation means for calculating the position of said object from the integrated value of said integrator.

9. The two-dimensional positioning apparatus of claim 8, further comprising: a base clock oscillator for generating a base clock whose frequency is higher than the frequency fc; an oscillator for generating the signal K2cosωct or K2sinωct from said base clock; and
a phase shifter for shifting the phase of the signal generated by said oscillator, thereby producing the signals K2cosωct and K2sinωct,
wherein the signals K2cosωct and K2sinωct generated by said phase shifter are supplied to said multiplier and said base clock is Supplied to said period counter as a period-measuring clock.

10. The two-dimensional positioning apparatus of claim 8, wherein
said multiplier multiplies the modulated signals K1sinωst and K1cosωst by the reference signals K2sinωct and K2cosωct, respectively, and
said adder adds the two multiplication signals to obtain the signal K1-K2cos(ωc -ωs)t.

## Patentansprüche

1. Zweidimensionale Positioniervorrichtung zum Positionieren eines Objekts in einer zweidimensionalen Richtung mit:
einer Platte (10), auf der Zähne (101) an festen. Beabstandungen entlang X- und Y- Achsen ausgebildet sind;
einem Gleitstück (11), das mit zwei X-Achsenmotoren (14, 15), zwei X-Achsenpositionssensoren (19, 20), einem Y-Achsenmotor (13) und einem Y-Achsenpositionssensor (18) versehen ist, wobei das Gleitstück (11) mit dem Objekt beladen wird und über der Platte (10) gehalten wird;
einem Wandler (36) zur Erzeugung von Signalen zum Erfassen einer X-Achsenposition des Mittelpunkts des Gleitstücks und eines Gierwinkels θ des Gleitstücks gemäß den Positionserfassungssignalen der beiden X-Achsenpositionssensoren (19, 20);
einem Xθ-Controller (40) zur getrennten Regelung der Bewegung des Gleitstücks (11) in den X-Achsen- und θ-Achsenrichtungen, gemäß den von dem Wandler (36) umgewandelten Signalen;
einer Befehlsumwandlungsschaltung (42) zum Umwandeln der Steuerausgabe des Xθ-Controllers (40) in Antriebsbefehle, die an die beiden X-Achsenmotoren (14, 15) zu geben sind; und
einem Y-Achsencontroller (21) zum Empfang des Positionserfassungssignals des X-Achsenpositionssensors (18) und der Rückkopplungssteuerung der Y-Achsenrichtung gemäß dem Positionserfassungssignal.

2. Zweidimensionale Positioniervorrichtung gemäß Anspruch 1 mit:
Schwebemittel (12), um das Gleitstück (11) über der Platte (10) schweben zu lassen;
wobei der Wandler (36) die Positionserfassungssignale der ersten und zweiten X-Achsenpositionssensoren (19, 20) empfängt und ein Signal zum Erfassen der X-Achsenposition des Mittelpunkts des Gleitstücks gemäß der Summe der Positionserfassungssignale erzeugt, und er ein Signal zum Erfassen des Gierwinkels θ des Gleitstücks (11) gemäß der Differenz zwischen den Positionserfassungssignalen erzeugt.

3. Zweidimensionale Positioniervorrichtung gemäß Anspruch 2, bei der die Befehlsumwandlungsschaltung (42) die von dem X-θ Controller (40) ausgegebenen X-Achsen- und θ-Achsen-Antriebsbefehle empfängt, um Antriebsbefehle zu erzeugen, die an die beiden X-Achsenmotoren (14, 15) gemäß der Summe von und der Differenz zwischen den X-Achsen- und θ-Achsen-Antriebsbefehlen zu geben sind.

4. Zweidimensionale Positioniervorrichtung gemäß Anspruch 2, ferner mit einem Begrenzer zum Einschränken der X-Achsengrenzen der Antriebsbefehle Ir0 auf Imax - |Ire|, wobei Imax der Maximalwert des Antriebsbefehls und Ire ein θ-Achsenantriebsbefehl ist, um dadurch die Grenzen des Antriebsbefehls Ir0 gemäß dem Betrag des θ-Achsenantriebsbefehls Ire einzuschränken.

5. Zweidimensionale Positioniervorrichtung gemäß Anspruch 2, bei die ersten und zweiten X-Achsenmotoren (14, 15) Kerne aufweisen, auf denen Zähne entgegengesetzt den Zähnen (101) der Platte (10) an festen Beabstandungen entlang der X-Achse ausgebildet sind, wobei die Kerne der ersten und zweiten X-Achsenmotoren (14, 15) symmetrisch um den Mittelpunkt des Gleitstücks (11) angeordnet sind.

6. Zweidimensionale Positioniervorrichtung gemäß Anspruch 2, bei der der Y-Achsenpositionssensor (18) und die ersten und zweiten X-Achsenpositionssensoren (19, 20) die Position optisch mittels Laserinterferometer erfassen und mit Tripelspiegeln ausgestattet sind, wobei der Tripelspiegel des X-Achsenpositionssensors an dem Mittelpunkt der X-Achse angeordnet ist, und die Tripelspiegel der ersten und zweiten X-Achsenpositionssensoren symmetrisch um die X-Achsenmittellinie des Gleitstücks (11) angeordnet sind.

7. Zweidimensionale Positioniervorrichtung gemäß Anspruch 1 oder.2 mit:
einer optischen Schaltung zum Erzeugen von Interferenzstreifen mit einem festen Abstand mittels optischer Interferenz, die sich bewegen, wenn sich ein erfasstes Objekt bewegt; und
mindestens einem Positionssensor (18, 19, 20) mit einem Phasendetektor zum Erfassen von Interferenzstreifen mittels einer Mehrzahl von Photodetektoren, die mit einer vorgegebenen Beabstandung in der Richtung ausgerichtet sind, in der die Interferenzstreifen angeordnet sind, und die zwei modulierte Signale erzeugen, die gemäß dem Betrag der von dem Objekt ausgeführten Bewegung moduliert werden,
wobei die zweidimensionale Positioniervorrichtung ferner umfasst:
einen Multiplizierer zum Multiplizieren der beiden modulierten Signale mittels von einem Basistakt erzeugten Bezugssignalen; und
einen Addierer zum Addieren der beiden Multiplikationssignale.

8. Zweidimensionale Positioniervorrichtung gemäß Anspruch 1 oder 2, bei der die Positionssensoren (18, 19, 20) Interferometer verwenden mit:
einer optischen Schaltung zum Erzeugen von Interferenzstreifen mit einem Abstand P mittels optischer Interferenz, die sich bewegen, wenn sich das Objekt bewegt;
einen Phasendetektor zum Erfassen von Interferenzstreifen mittels einer Mehrzahl von Photodetektoren, die mit einer Phasenverschiebung von etwa P/4-Abstand voneinander in der Richtung angeordnet sind, in der die Interferenzstreifen angeordnet sind, und zum Erzeugen der modulierten Signale K1sinωst und K1cosωst (K1 ist eine Konstante und t die Zeit), deren Kreisfrequenz ωs gemäß dem Betrag der von dem Objekt ausgeführten Bewegung moduliert wird, aus von der Mehrzahl von Photodetektoren erfassten Signalen;
einem Multiplizierer zum Multiplizieren der modulierten Signale K1sinωst und K1cosωst durch die Bezugssignale K2cosωct bzw. K2sinωct (ωc >> ωs), die von einem Basistakt erzeugt werden;
einem Addierer zum Addieren der beiden Multiplikationssignale, um das Signal K1 - K2sin(ωc + ωs)t zu erhalten;
einem Komparator zum Umwandeln des Additionssignals in ein Impulssignal;
einem Frequenzteiler zum Teilen des Impulssignals mit einem Teilungsverhältnis von n (n ist eine ganze Zahl);
einem Periodenzähler zum Messen der Periode n/(fs + fc) (ωc = 2Jtfc und ωs = 2Jtfs) eines frequenzgeteilten Signals, das von dem Frequenzteiler durch Verwenden eines Takts erhalten wird, der mit dem Basistakt synchronisiert ist und dessen Periode verglichen mit der Periode des frequenzaufgeteilten Signals ausreichend kurz ist;
einem Subtrahierer zum Finden der Differenz zwischen der gemessenen Periode des Periodenzählers und der Periode nlfc eines Bezugssignals;
einen Integrator zum Integrieren der Periodendifferenz des Subtrahierers in Intervallen von n/(fs + fc); und
einem Positionsberechnungsmittels zum Berechnen der Position des Objekts aus dem von dem Integrator integrierten Wert.

9. Zweidimensionale Positioniervorrichtung gemäß Anspruch 8, ferner mit:
einem Basistaktoszillator zum Erzeugen eines Basistaktes, dessen Frequenz höher als die Frequenz fc ist;
einem Oszillator zum Erzeugen des Signals K2cosωct oder K2sinωct aus dem Basistakt; und
einem Phasenverschieber zum Verschieben der Phase des von dem Oszillator erzeugten Signals, wodurch die Signale K2cosωct und K2sinωct erzeugt werden,
wobei die von dem Phasenverschieber erzeugten Signale K2cosωct und K2sinωct an den Multiplizierer geliefert werden, und der Basistakt an den Periodenzähler als ein Periodenmesstakt geliefert wird.

10. Zweidimensionale Positioniervorrichtung gemäß Anspruch 8, bei der
der Multiplizierer die modulierten Signale K1sinωst und K1cosωst durch die Bezugssignale K2sinωct bzw. K2cosωct multipliziert, und der Addierer die beiden Multiplikationssignale addiert, um das Signal K1 - K2cos(ωc-ωs)t erhalten.

## Revendications

1. Appareil de positionnement bidimensionnel destiné à positionner un objet de manière bidimensionnelle, comprenant :
un plateau (10) sur lequel des dents (101) sont formées avec des espacements fixes le long d'axes X et Y,
un coulisseau (11) muni de deux moteurs (14, 15) d'axe X, de capteurs (19, 20) de position d'axe X, d'un moteur (13) d'axe Y et d'un capteur (18) de position d'axe Y, le coulisseau (11) étant chargé de l'objet et subissant une lévitation au-dessus du plateau (10),
un convertisseur (36) destiné à produire des signaux de détection d'une position d'axe X du point central du coulisseau et d'un angle de lacet θ du coulisseau en fonction des signaux de détection de position des deux capteurs (19, 20) de position d'axe X,
un organe (40) de commande Xθ destiné à la commande à réaction du déplacement du coulisseau (11) dans les directions de l'axe X et de l'axe θ séparément en fonction des signaux transformés par le convertisseur (36),
un circuit (42) de conversion de commande destiné à transformer le signal de sortie de commande de l'organe de commande Xθ (40) en commandes de propulsion destinées aux deux moteurs (14, 15) d'axe X, et
un organe (21) de commande d'axe Y destiné à recevoir le signal de détection de position du capteur (18) de position d'axe Y et à commander par réaction la direction d'axe Y en fonction du signal de détection de position.

2. Appareil de positionnement bidimensionnel selon la revendication 1, comprenant :
un dispositif (12) de lévitation du coulisseau (11) au-dessus du plateau (10),
le convertisseur (36) recevant les signaux de détection de position des premier et second capteurs (19, 20) de position d'axe X et produisent un signal de détection de la position d'axe X du point central du coulisseau en fonction de la somme des signaux de détection de position, et produisant un signal de détection de l'angle de lacet θ du coulisseau (11) en fonction de la différence entre les signaux de détection de position.

3. Appareil de positionnement bidimensionnel selon la revendication 2, dans lequel le circuit (42) de conversion de commande reçoit des commandes de propulsion d'axe X et d'axe θ transmises par l'organe (40) de commande Xθ pour la production de commandes de propulsion destinées aux deux moteurs (14, 15) d'axe X en fonction de la somme et de la différence entre les commandes de propulsion d'axe X et d'axe θ.

4. Appareil de positionnement bidimensionnel selon la revendication 2, comprenant en outre un limiteur destiné à délimiter les limites d'axe X de la commande de propulsion Ir0 à Imax - |Ire|, Imax étant la valeur maximale de la commande de propulsion et Ire étant une commande de propulsion d'axe θ, et limitant ainsi les limites de la commande de propulsion Ir0 en fonction de l'amplitude de la commande de propulsion d'axe θ Ire.

5. Appareil de positionnement bidimensionnel selon la revendication 2, dans lequel les premier et second moteurs (14, 15) d'axe X sont des noyaux sur lesquels sont formées des dents qui sont opposées aux dents (101) du plateau (10) ayant des espacements fixes le long de l'axe X, les noyaux des premier et second moteurs (14, 15) d'axe X étant disposés symétriquement par rapport au point central du coulisseau (11).

6. Appareil de positionnement bidimensionnel selon la revendication 2, dans lequel le capteur (18) de position d'axe Y et les premier et second capteurs (19, 20) de position d'axe X détectent optiquement la position à l'aide d'interféromètres laser et possèdent des dispositifs catadioptriques, le dispositif catadioptrique du capteur de position d'axe Y étant placé au point central de l'axe Y et les dispositifs catadioptriques des premier et second capteurs de position d'axe X étant disposés symétriquement par rapport à l'axe central d'axe X du coulisseau (11).

7. Appareil de positionnement bidimensionnel selon la revendication 1 ou 2, comprenant :
un circuit optique destiné à produire avec un pas fixe, par interférence optique, des franges d'interférences qui se déplacent lorsqu'un objet détecté se déplace, et
au moins un capteur (18, 19, 20) de position ayant un détecteur de déphasage destiné à détecter les franges d'interférences à l'aide de plusieurs photodétecteurs ayant un espacement déterminé dans la direction dans laquelle les franges d'interférences sont alignées et produisant deux signaux modulés qui sont modulés en fonction de l'amplitude du déplacement effectué par l'objet,
dans lequel l'appareil de positionnement bidimensionnel comporte en outre
un multiplicateur destiné à multiplier les deux signaux modulés par des signaux de référence créés par une horloge de base, et
un additionneur destiné à additionner les deux signaux de multiplication.

8. Appareil de positionnement bidimensionnel selon la revendication 1 ou 2, dans lequel les capteurs (18, 19, 20) de position utilisent des interféromètres, et comprenant :
un circuit optique destiné à produire avec un pas fixe, par interférence optique, des franges d'interférences qui se déplacent lorsque l'objet se déplace,
un détecteur de déphasage destiné à détecter les franges d'interférences à l'aide de plusieurs photodétecteurs qui sont disposés avec un déphasage pouvant atteindre P/4 pas les uns par rapport aux autres, dans la direction dans laquelle les franges d'interférences sont alignées, et produisant les signaux modulés K1sinωst et K1cosωst (K1 étant une constante et t le temps), dont la fréquence angulaire ωs est modulée d'après l'amplitude du déplacement effectué par l'objet, à partir de signaux détectés par les photodétecteurs,
un multiplicateur destiné à multiplier les signaux modulés K1sinωst et K1cosωst par les signaux de référence K2cosωct et K2sinωct (ωc >> ωs) respectivement qui sont créés à partir dune horloge de base,
un additionneur destiné à additionner les deux signaux de multiplication pour donner le signal K1 - K2sin(ωc + ωs)t,
un comparateur destiné à transformer le signal d'addition en un signal pulsé,
un diviseur de fréquence destiné à diviser le signal pulsé avec un rapport de division n (n étant un nombre entier),
un compteur de période destiné à mesurer la période n/(fs + fc) (ωc = 2Jtfc et ωs = 2Jtfs) du signal divisé en fréquence obtenu du diviseur de fréquence à l'aide dune horloge qui est synchronisée sur l'horloge de base et dont la période est suffisamment courts par rapport à celle du signal ayant subi la division de fréquence,
un circuit de soustraction destiné à déterminer la différence entre la période mesurée par le compteur de période et la période n1fc d'un signal de référence,
un intégrateur destiné à intégrer la différence de période du circuit de soustraction à des intervalles de n/(fs + fc), et
un dispositif de calcul de position destiné à calculer la position de l'objet d'après la valeur intégrée de l'intégrateur.

9. Appareil de positionnement bidimensionnel selon la revendication 8, comprenant en outre un oscillateur d'horloge de base destiné à créer une horloge de base dont la fréquence est supérieure à la fréquence fc, un oscillateur destiné à créer le signal K2cosωct ou K2sinωct à partir de l'horlog de base, et
un déphaseur destiné à déphaser le signal créé par l'oscillateur, en produisant ainsi les signaux K2cosωct et K2sinωct,
dans lequel les signaux K2cosωct et K2sinωct créés par le déphaseur sont transmis un multiplicateur et l'horloge de base est transmise au compteur de période sous forme d'une horloge de mesure de période.

10. Appareil de positionnement bidimensionnel salon la revendication 8, dans lequel
le multiplicateur multiplie les signaux modulés K1sinωst et K1cosωst par les signaux de référence K2sinωct et K2cosωct respectivement, et
l'additionneur ajoute les deux signaux de multiplication pour donner le signal K1 - K2cos(ωc - ωs)t.
